# EUROPEAN PATENT APPLICATION

(11) **EP 4 622 414 A1**
(43) Date of publication of application: **24.09.2025**
(21) Application number: 25164226.0
(22) Date of filing: 17.03.2025
(51) Int. Cl.: H05K 9/00

(54) **ELECTRICAL DEVICE, ELECTRIC DRIVE ASSEMBLY SYSTEM AND VEHICLE**

(30) Priority: 18.03.2024 CN 202420532956 U
(71) Applicant: Valeo eAutomotive Shenzhen Co., Ltd, Shenzhen Guangdong 518128 (CN)
(72) Inventor: HU, Dong, Shenzhen, 518128 (CN); XU, Kangfa, Shenzhen, 518128 (CN); XU, Xiaoting, Shenzhen, 518128 (CN); QU, Gongyuan, Shenzhen, 518128 (CN)
(74) Representative: Valeo Powertrain Systems

(57) **Abstract**

The present disclosure provides an electrical device, an electric drive assembly system and a vehicle. The electrical device includes: a housing; a circuit board, which is arranged in the housing and provided with a recess thereon; and a shielding element, which is arranged on the circuit board and abuts the housing, wherein the shielding element includes a first plug-in part and a second plug-in part capable of being inserted into a corresponding recess on the circuit board, the first plug-in part having a deformable protrusion protruding in a first direction transverse to a plug-in direction, and the second plug-in part having a deformable protrusion protruding in a second direction opposite to the first direction.

## Description

### Technical Field

The present disclosure relates to an electrical device, an electric drive assembly system and a vehicle.

### Background Art

Modern motor vehicles are usually equipped with electrical devices to support various electrical functions of the vehicle, such as vehicle intelligence. Various electrical devices are also installed in electric vehicles, such as an electric motor controller, an on-board charger (OBC), a DC-DC converter (DCDC), a high voltage power distribution unit (PDU), etc. installed in an electric drive assembly system.

Multiple high-voltage and low-voltage electronic elements installed in electrical devices generate electromagnetic waves to the outside world during operation, and electromagnetic waves in some frequency bands can cause electromagnetic interference (EMI) to the normal operation of some components or apparatuses; such electromagnetic interference can cause intermittent failure of devices, permanently damaging components when serious. Failure or damage to vehicle components can lead to the vehicle having a major accident, threatening the lives and safety of the occupants.

The product quality of electrical devices and vehicles is generally evaluated by EMC (electromagnetic compatibility); the "EMC" refers to the capability of a device or system to operate in compliance with requirements in its electromagnetic environment and not to cause unbearable electromagnetic interference to any device in its environment. EMC comprises two requirements: first, it is required that the electromagnetic interference generated by devices to their environment in the process of operation cannot exceed a specified limit; second, it is required that the devices have a certain degree of immunity to the electromagnetic interference in the environment, i.e. electromagnetic susceptibility (EMS).

To protect electrical components, especially sensitive components of printed circuit boards, from EMI and to meet EMC requirements, EMC protective structures are usually provided around important components of electronic devices. A common EMC protective structure is an EMC shielding elastic piece, which is usually pre-fixed to a printed circuit board by means of tooling. However, this leads to cumbersome production processes and high production costs, which reduce production efficiency. In addition, in some known technical solutions, the mounting stability of EMC shielding elastic pieces is insufficient, resulting in insufficient protection.

### Summary of the Invention

It is therefore an object of the present disclosure to provide an electrical device, an electric drive assembly system and a vehicle, wherein assembly of a shielding element in the electrical device is simple, reducing production costs and increasing production efficiency.

The abovementioned object is achieved through the electric motor, the electric drive assembly system and the vehicle which are described below.

The present disclosure provides an electrical device, the electrical device comprising: a housing; a circuit board, which is arranged in the housing and provided with a recess thereon; and a shielding element, which is arranged on the circuit board and abuts the housing, wherein the shielding element comprises a first plug-in part and a second plug-in part capable of being inserted into a corresponding recess on the circuit board, the first plug-in part having a deformable protrusion protruding in a first direction transverse to a plug-in direction, and the second plug-in part having a deformable protrusion protruding in a second direction opposite to the first direction. The deformable protrusion of the plug-in part can be in interference fit with the circuit board, thus pre-positioning the shielding element, simplifying the assembly process and reducing production costs. In addition, the protrusions of opposite directions cause the pre-positioning of the shielding element to be more stable.

The electrical device according to the present disclosure may also have one or more of the following features, alone or in combination.

In one embodiment, the deformable protrusion extends in the plug-in direction, and two ends thereof are both connected to a main body of the corresponding plug-in part. In this way, the deformable protrusion of the plug-in part can have a more robust interference fit with the circuit board, and removal of the shielding element is also easy to achieve.

In one embodiment, the deformable protrusion is a stamp-formed part that protrudes from the main body of the corresponding plug-in part. In this way, the protrusions do not need to be mounted by an additional connection step, simplifying the processing process, thus facilitating an increase in production efficiency and improving structural strength.

In one embodiment, the shielding element further comprises multiple elastic piece bodies, the elastic piece bodies abut the housing and are spaced apart from each other in an extension direction of a main body of the shielding element. In this way, the electromagnetic isolation of the high-voltage and low-voltage areas on the circuit board can be better achieved, electric field coupling is reduced, and the EMC effect of the product is improved. In addition, the shielding element is easier to manufacture and is less prone to deformation.

In one embodiment, a free end of the elastic piece body is provided with a bent part, and the bent part abuts the housing. In this way, not only can a compressive force be provided between the shielding element and the housing, which makes the shielding element more stably mounted in the electrical device, but also product tolerance can be absorbed, further improving product quality.

In one embodiment, the elastic piece body extends obliquely from the main body of the shielding element to the top cover of the housing. In this way, deformation of the shielding element can be prevented, thus improving the EMC shielding effect.

In one embodiment, the shielding element further comprises a welding part in surface contact with the circuit board and extending in an extension direction of a main body of the shielding element. In this way, a fixed mounting of the shielding element can be achieved by welding, and a larger grounding area is provided, which in turn helps to reduce the impedance, improving the EMC shielding effect.

In one embodiment, the welding part comprises a first welding part and a second welding part, the first welding part extending in a second direction and the second welding part extending in a first direction. The mounting of the shielding element is made more stable by means of welding parts arranged in opposite directions.

In one embodiment, the first plug-in part is arranged between first welding parts, and the second plug-in part is arranged between second welding parts. This arrangement allows both the pre-positioning and the fixing of the shielding element to be carried out in a stable state.

In one embodiment, the shielding element is a stamped member which is integrally formed. In this way, an additional connection step is not necessary in the manufacture of the shielding element, simplifying the processing process, thus facilitating an increase in production efficiency and improving structural strength.

In one embodiment, the printed circuit board comprises a first electronic element and a second electronic element, and the electrical device comprises a first area and a second area, the first electronic element being located in the first area, the second electronic element being located in the second area, and the shielding element being used to prevent electromagnetic interference between the first electronic element and the second electronic element. In this way, EMC shielding of a high-voltage area and a low-voltage area on the circuit board can be achieved.

The present disclosure further provides an electric drive assembly system, which comprises the electrical device described above.

The present disclosure further provides a vehicle, which comprises the electric drive assembly system described above.

### Brief Description of the Drawings

A better understanding of the advantages and objective of the present disclosure can be gained from the preferred embodiments of the present disclosure described in detail below with reference to the drawings. To better illustrate the relationships among components in the drawings, the drawings are not drawn to scale. In the drawings:
Fig. 1 is a schematic drawing of an electrical device according to an embodiment of the present disclosure;
Fig. 2 is a schematic drawing of the interior of the electrical device according to Fig. 1;
Fig. 3 is a schematic drawing of a shielding element of an electrical device according to an embodiment of the present disclosure;
Fig. 4 is a top view of the shielding element according to Fig. 3;
Fig. 5 is a side view of the shielding element according to Fig. 3; and
Fig. 6 is a schematic drawing of a plug-in part of a shielding element of an electrical device according to an embodiment of the present disclosure.

### Detailed Description of the Invention

In order to clarify the technical solution objective, the technical solution and advantages of the present disclosure, the technical solution of embodiments of the present disclosure is described clearly and completely below in conjunction with the drawings accompanying particular embodiments of the present disclosure. In the drawings, identical reference numerals denote identical components. It must be explained that the embodiments described are some, not all, of the embodiments of the present disclosure. All other embodiments obtained by those skilled in the art based on the described embodiments of the present disclosure without the need for inventive effort shall fall within the scope of protection of the present disclosure.

Unless otherwise defined, the technical or scientific terms used herein shall have the common meanings understood by those skilled in the art. The words "first", "second", and the like used in the description and claims of the patent application disclosed herein do not indicate any order, quantity or importance, being merely used to distinguish different component parts. Likewise, words such as "a" or "one" do not necessarily represent a quantity limit. Words such as "comprising", "including" or "having" mean that the element or object preceding the word covers the elements or objects listed after the word and equivalents thereof, without excluding other elements or objects. Words such as "connection" or "communication", rather than being limited to the physical or mechanical connection or communication shown in a drawing, may comprise connection or communication equivalent thereto, irrespective of whether it is direct or indirect. The terms "upper", "lower", "left", "right" and the like are only used to indicate a relative positional relationship, and when the absolute position of a described object changes, the relative positional relationship may also change accordingly.

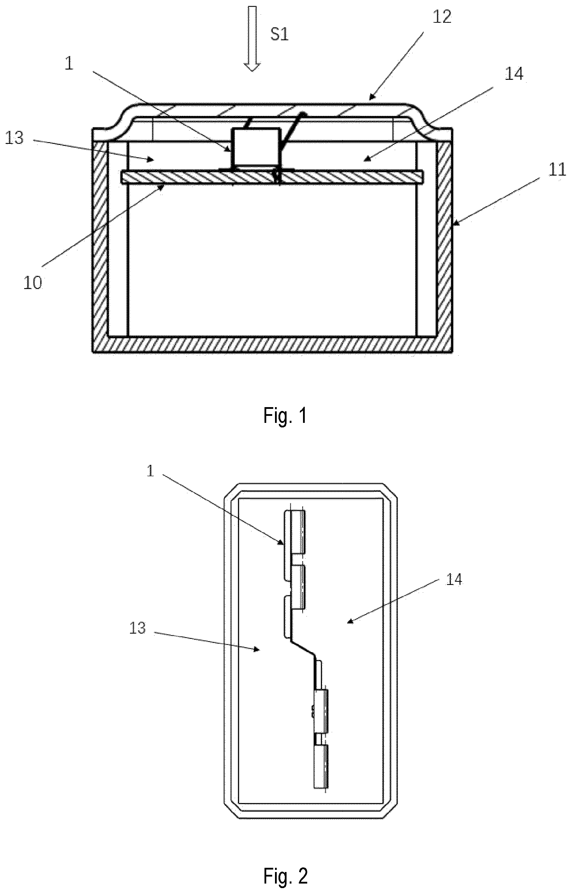

Embodiments of the present disclosure are described in detail below with reference to Figs. 1 - 6.

In an electric drive assembly system of a vehicle according to one embodiment of the present disclosure, one or more electrical devices are provided which may be mounted with the electric drive assembly system at the front end of the vehicle or at the vehicle underbody. Electrical devices can comprise at least one of the following: electric motor controllers, on-board chargers (OBC), DC converters (DC-DC), power distribution units (PDUs), etc. Electrical devices can comprise various electronic elements.

As shown in Fig. 1, an electrical device according to an embodiment of the present disclosure comprises: a housing 11, a circuit board 10 and a shielding element 1.

The housing 11 forms an accommodating space and comprises a top cover 12 which can be used to enclose the accommodating space.

The circuit board 10 is arranged in the housing 11, and provided with a recess thereon. For example, the recess is a recessed opening or a through-opening on the circuit board 10. For example, the circuit board 10 comprises a first electronic element and a second electronic element, and the electrical device comprises a first area 13 and a second area 14. The first electronic element is located in the first area 13, and the second electronic element is located in the second area 14. For example, the first electronic element comprises various high voltage elements, and the second electronic element comprises various low voltage elements.

The shielding element 1 is arranged on the circuit board 10 and abuts the housing 11. For example, the shielding element 1 abuts the top cover 12.

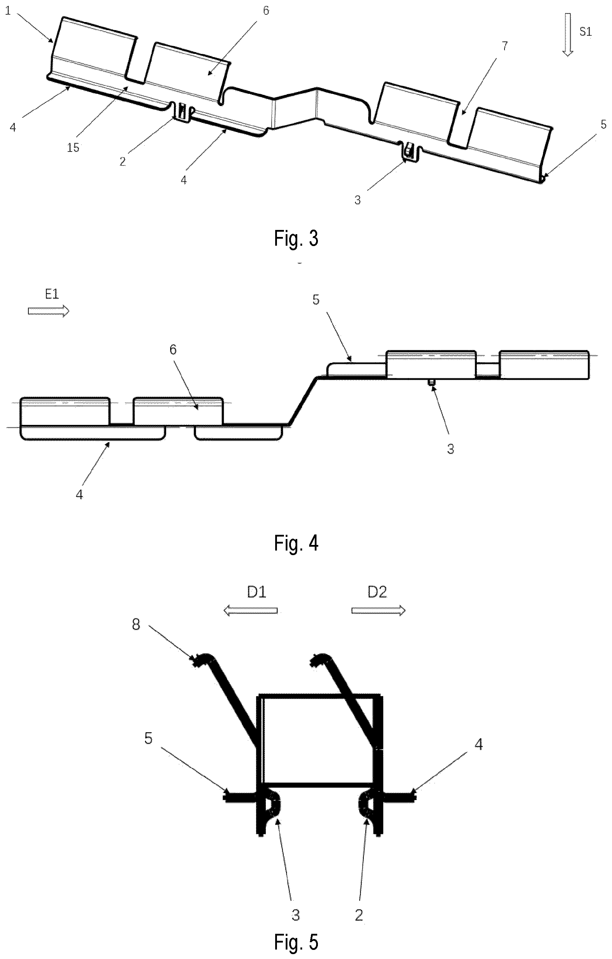

As shown in Fig. 3, the shielding element 1 comprises a first plug-in part 2 and a second plug-in part 3 capable of being inserted into a corresponding recess on the circuit board 10. One first plug-in part 2 and one second plug-in part 3 are shown in the drawing, but the present disclosure does not limit the number of each of the first plug-in part 2 and the second plug-in part 3. As shown in Fig. 5, the first plug-in part 2 has a deformable protrusion protruding in a first direction D1 transverse to a plug-in direction S1, and the second plug-in part 3 has a deformable protrusion protruding in a second direction D2 opposite to the first direction D1. Figs. 1, 3 and 5 show schematically, using arrows, the plug-in direction S1, the first direction D1 and the second direction D2, wherein the plug-in direction S1 is, for example, perpendicular to the circuit board 10. The deformable protrusion of the first plug-in part 2 and the deformable protrusion of the second plug-in part 3 are supported on an inner wall of the corresponding recess on the circuit board 10.

The deformable protrusion of the above plug-in part can be in interference fit with the circuit board, thus pre-positioning the shielding element, simplifying the assembly process and reducing production costs. In addition, the protrusions of opposite directions cause the pre-positioning of the shielding element to be more stable.

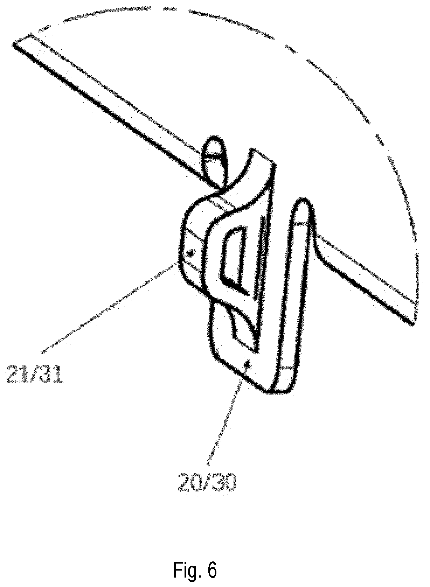

As shown in Fig. 6, the deformable protrusion 21/31 extends in the plug-in direction S1, and two ends thereof are both connected to a main body 20/30 of the corresponding plug-in part. For example, the connection of the deformable protrusion 21/31 to the corresponding main body 20/30 is a smooth transition part with curvature. In this way, the deformable protrusion of the plug-in part can have a more robust interference fit with the circuit board, and removal of the shielding element is also easy to achieve. In some examples, the first plug-in part 2 and the second plug-in part 3 may have the same form, as shown in Fig. 6, but in other examples, the first plug-in part 2 and the second plug-in part 3 may have different forms from each other.

Referring again to Fig. 6, the deformable protrusion 21/31 is a stamp-formed part that protrudes from the main body 20/30 of the corresponding plug-in part. In this way, the protrusions do not need to be mounted by an additional connection step, simplifying the processing process, thus facilitating an increase in production efficiency and improving structural strength.

As shown in Figs. 3 and 4, the shielding element 1 further comprises multiple elastic piece bodies 6, the elastic piece bodies abut the housing 11 and are spaced apart from each other in an extension direction E1 of a main body 15 of the shielding element 1. For example, the elastic piece bodies 6 may be four in number, and other numbers are also possible. As shown in Fig. 2, the extension direction E1 of the shielding element 1 may be parallel to the length direction of the housing 11; of course, it may also be parallel to the width direction. For example, multiple elastic piece bodies 6 are spaced apart from each other by cut-outs 7. By providing the elastic piece bodies abutting the housing, the electromagnetic isolation of the high-voltage and low-voltage areas on the circuit board can be better achieved, electric field coupling is reduced, and the EMC effect of the product is improved. In addition, the shielding element is easier to manufacture and is less prone to deformation due to the fact that multiple elastic piece bodies are spaced apart from each other.

As shown in Figs. 3 and 5, a free end of the elastic piece body 6 is provided with a bent part 8, and the bent part 8 abuts the housing 11, as shown in Fig. 1, for example abutting the inner surface of the top cover 12 of the housing 11. In this way, not only can a compressive force be provided between the shielding element and the housing, which makes the shielding element more stably mounted in the electrical device, but also product tolerance can be absorbed, further improving product quality. The cut-outs 7 between the above elastic piece bodies 6 make the formation of the bent parts 8 easier, and the quality of the bent part 8 better.

As shown in Fig. 1, the elastic piece body 6 extends obliquely from the main body 15 of the shielding element 1 to the top cover 12 of the housing 11. This oblique extension can avoid deformation of the shielding element, thus improving the EMC shielding effect.

As shown in Figs. 3 to 5, the shielding element 1 further comprises a welding part in surface contact with the circuit board 10 and extending in an extension direction E1 of a main body 15 of the shielding element 1. Compared to known solutions employing screw fastening, the present disclosure can achieve a fixed mounting of the shielding element by welding, enabling a close fit of the shielding element to the circuit board, thereby increasing a contact area of the shielding element with the circuit board, therefore providing a larger grounding area for the shielding element, which in turn helps to reduce the impedance, improving the EMC shielding effect. For example, the welding part comprises a first welding part 4 and a second welding part 5, the first welding part 4 extending in a second direction D2 and the second welding part 5 extending in a first direction D1. The mounting of the shielding element is more stable by setting the welding parts in opposite directions.

Referring again to Fig. 3, the first plug-in part 2 is arranged between first welding parts 4, and the second plug-in part 3 is arranged between second welding parts 5. That is, the plug-in part as a predetermined positioning part and the welding part as a fixing part can be arranged alternately. This makes it possible to rationally arrange the predetermined positioning parts and the fixing parts along the extension direction E1 of the main body 15 of the shielding element 1, so that both the predetermined positioning and the fixing of the shielding element can be carried out in a stable state.

For example, the shielding element 1 is a stamped member which is integrally formed. The shielding element 1 can be stamped and formed from sheet metal in one piece. In this way, an additional connection step is not necessary in the manufacture of the shielding element, simplifying the processing process, thus facilitating an increase in production efficiency and improving structural strength.

For example, the material of the shielding element 1 may be a conductive metal, such as phosphor bronze. Phosphor bronze material has good toughness, high relative conductivity, and a good shielding effect for high and low voltage electric field coupling. In addition, the material surface of the shielding element 1 can be plated with nickel-tin, which helps to improve the oxidation resistance and weldability of the product.

Referring again to Figs. 1 and 2, the shielding element 1 can be used to prevent electromagnetic interference between a first electronic element located in a first area 13 and a second electronic element located in a second area 14. In this way, EMC shielding of a high-voltage area and a low-voltage area on the circuit board can be achieved.

According to the division of the first area 13 and the second area 14, the shielding element 1 may have a bent part, which is located between the elastic piece bodies 6 or between the first welding part 4 and the second welding part 5, as shown in Fig. 3.

The electric drive assembly system according to an embodiment of the present disclosure may comprise the electrical device as described above. It should be understood that the electric drive assembly system of the present disclosure also has the advantages described above in relation to the electrical device.

A vehicle according to an embodiment of the present disclosure comprises the electric drive assembly system as described above. The vehicle may be an electrified vehicle, such as a battery electric vehicle (BEV), a hybrid electric vehicle (HEV), a plug-in hybrid electric vehicle (PHEV) or a range-extended electrified vehicle (REEV). The vehicle may also be a hydrogen-powered vehicle. It should be understood that the vehicle of the present disclosure also has the advantages described above in relation to the electrical device.

In addition, the technical features disclosed above are not limited to combinations of the disclosed features with other features, and those skilled in the art could combine technical features in other ways according to the objective of the invention, to realize the objective of the present disclosure.

## Claims

1. An electrical device, **characterized in that** the electrical device comprises:
a housing (11);
a circuit board (10), which is arranged in the housing and provided with a recess thereon; and
a shielding element (1), which is arranged on the circuit board (10) and abuts the housing (11),
wherein the shielding element (1) comprises a first plug-in part (2) and a second plug-in part (3) capable of being inserted into a corresponding recess on the circuit board (10), the first plug-in part (2) has a deformable protrusion protruding in a first direction (D1) transverse to a plug-in direction (S1), and the second plug-in part (3) has a deformable protrusion protruding in a second direction (D2) opposite to the first direction (D1).

2. The electrical device according to claim 1, **characterized in that** the deformable protrusion extends in the plug-in direction (S1), and two ends thereof are both connected to a main body of the corresponding plug-in part.

3. The electrical device according to claim 1, **characterized in that** the deformable protrusion is a stamp-formed part that protrudes from the main body of the corresponding plug-in part.

4. The electrical device according to claim 1, **characterized in that** the shielding element (1) further comprises multiple elastic piece bodies (6), the elastic piece bodies abut the housing (11) and are spaced apart from each other in an extension direction (E1) of a main body of the shielding element (1).

5. The electrical device according to claim 4, **characterized in that** a free end of the elastic piece body (6) is provided with a bent part (8), and the bent part abuts the housing (11).

6. The electrical device according to claim 4, **characterized in that** the elastic piece body (6) extends obliquely from the main body of the shielding element (1) to a top cover (12) of the housing (11).

7. The electrical device according to claim 1, **characterized in that** the shielding element (1) further comprises a welding part in surface contact with the circuit board (10) and extending in an extension direction (E1) of a main body of the shielding element (1).

8. The electrical device according to claim 7, **characterized in that** the welding part comprises a first welding part (4) and a second welding part (5), the first welding part extends in the second direction (D2), and the second welding part (5) extends in the first direction (D1).

9. The electrical device according to claim 8, **characterized in that** the first plug-in part (2) is arranged between the first welding parts (4), and the second plug-in part (3) is arranged between the second welding parts (5).

10. The electrical device according to claim 1, **characterized in that** the shielding element (1) is an integrally formed stamped member.

11. The electrical device according to claim 1, **characterized in that** the circuit board (10) comprises a first electronic element and a second electronic element, the electrical device comprises a first area (13) and a second area (14), the first electronic element is located in the first area (13), the second electronic element is located in the second area (14), and the shielding element (1) is used to prevent electromagnetic interference between the first electronic element and the second electronic element.

12. An electric drive assembly system, comprising the electrical device according to any one of claims 1 to 11.

13. A vehicle, comprising the electric drive assembly system according to claim 12.
